# EUROPEAN PATENT APPLICATION

(11) **EP 2 128 778 A1**
(43) Date of publication of application: **02.12.2009**
(21) Application number: 07738996.3
(22) Date of filing: 19.03.2007
(51) Int. Cl.: G06F 19/00

(54) **SIMULATION CONTROL PROGRAM, RECORDING MEDIUM, SIMULATOR AND SIMULATION CONTROL METHOD**

(71) Applicant: Fujitsu Limited, Kawasaki-shi, Kanagawa 211-8588 (JP)
(72) Inventor: INADA, Yoshie, Kawasaki-shi Kanagawa 211-8588 (JP)
(74) Representative: Stebbing, Timothy Charles
(86) International application number: PCT/JP2007/055553
(87) International publication number: WO 2008/126196

(57) **Abstract**

A simulation apparatus (10) performs a plurality of simulations, each at a different time step interval, in parallel. The simulation apparatus (10) calculates results of the simulations based on a plurality of execute objects operating at different time steps specified by a user. The simulation apparatus (10) stores the results of the processed simulations in a shared table (15a), and outputs the results to a visualizing apparatus (20). The simulation apparatus (10) determines whether the shared table (15a) stores simulation data more accurate than processed simulation data. If the processed simulation data is more accurate, the simulation apparatus (10) writes the simulation data to the shared table (15a), and outputs the simulation data to the visualizing apparatus (20).

## Description

### TECHNICAL FIELD

The present invention relates to a simulation control program, a storage medium, a simulation apparatus, and a simulation control method for performing a simulation at time step intervals and outputting processed data at each step.

### BACKGROUND ART

In a conventional disaster-related or disaster-prevention-related simulation method, a simulation is performed at predetermined time step intervals, and data output at each step is displayed in real time. For example, assuming that a time step interval is 0.01 second to simulate a condition after 10 seconds, simulation is performed for 1000 steps. Data resulting from the simulation is output at each time step, and a new simulation is performed based on the simulation result obtained at the prior time step. The time required for a simulation is the same for each time step regardless of the length of the time step interval.

Therefore, if the time step interval is set to a small value, highly accurate results can be obtained from the simulation. However, because the number of calculation steps increases, the processing time also increases. On the contrary, if the time step interval is set to a large value, the simulation can be processed faster, which enables the results to be reported quickly; however, only less accurate results can be obtained from the simulation.

Related to a simulation in which accuracy of simulation results is in a trade-off relationship with the processing time, conventional technologies have been proposed to reduce the processing time as well as to improve the accuracy. For example, according to such a conventional technology, a low accurate simulation model and a high accurate simulation model are prepared beforehand. Then, an area to be simulated is spatially segmented into areas, and the simulation is performed with a required accuracy for each of the areas (Patent Document 1). Another conventional technology has been proposed as a disaster-related simulation or disaster-prevention-related simulation method (Patent Document 2). According to this conventional technology, a low accurate simulation is first performed based on primary disaster-related information. An area is then selected based on the result of the simulation, and a high accurate simulation is performed thereto based on secondary disaster-related information.

[Patent Document 1] Japanese Laid-open Patent Publication No. 2002-259888
[Patent Document 2] Japanese Laid-open Patent Publication No. 11-143350

### DISCLOSURE OF INVENTION

### PROBLEM TO BE SOLVED BY THE INVENTION

However, the above conventional technologies do not suggest a method of performing simulations at predetermined time step intervals. The conventional technologies only suggest to perform a low accurate primary simulation, narrow down the area and the like based on the result of the primary simulation, and perform a high accurate secondary simulation. That is, the conventional technologies do not suggest a method suitable for improving both the accuracy and the reporting speed as a simulation method for performing a simulation at predetermined time step intervals and outputting data processed at each step.

The present invention has been achieved to solve the above problems in the conventional technology and it is an object of the present invention to provide a simulation method for performing a simulation at predetermined time step intervals and outputting data processed at each step, which enables a simulation suitable for improving both the accuracy and the reporting speed.

### MEANS FOR SOLVING PROBLEM

To overcome the problems and achieve the object mentioned above, according to the present invention, a simulation control program causes a computer to implement a method for performing a simulation at a predetermined time step interval and outputting a result of the simulation performed at each step. The simulation control program causes the computer to perform performing a plurality of simulations, each at a different time step interval, in parallel, and outputting results of the simulations performed at the performing.

Further, according to the present invention, the outputting includes outputting the results of the simulations performed at the performing to a shared output unit.

Still further, according to the present invention, the outputting includes, when there is a simulation result more accurate than the results of the simulations performed at the performing, updating the results of the simulations with the simulation result before outputting the results of the simulations.

Still further, according to the present invention, the simulation control program further causes the computer to perform allocating processors to the simulations, respectively, according to a predetermined condition. The performing includes performing the simulations in parallel using the processors allocated at the allocating.

Still further, according to the present invention, the simulation control program further causes the computer to perform re-allocating, when a simulation is completed at the performing, a processor allocated to the simulation to another simulation. The performing includes performing the other simulation using the processor allocated at the re-allocating.

Still further, according to the present invention, the simulation control program further causes the computer to perform storing the results of the simulations performed at the performing to a predetermined storage unit having a link structure.

According to the present invention, a computer-readable recording medium stores therein a simulation control program that causes a computer to perform a simulation at a predetermined time step interval and output a result of the simulation performed at each step. The simulation control program causes the computer to perform performing a plurality of simulations, each at a different time step interval, in parallel, and outputting results of the simulations performed at the performing.

According to the present invention, a simulation apparatus performs a simulation at a predetermined time step interval and outputs a result of the simulation performed at each step. The simulation apparatus includes a simulation performing unit that performs a plurality of simulations, each at a different time step interval, in parallel, and a result outputting unit that outputs results of the simulations performed by the simulation performing unit.

According to the present invention, a simulation control method for performing a simulation at a predetermined time step interval and outputting a result of the simulation performed at each step, includes performing a plurality of simulations, each at a different time step interval, in parallel, and outputting results of the simulations performed at the performing.

### EFFECT OF THE INVENTION

According to the present invention, a plurality of simulations, each operating at different time step intervals, is performed in parallel, and then the results of processed simulations are output. Therefore, the result of a simulation operating at longer time step intervals can be obtained quickly. At the same time, a more accurate simulation result can be obtained subsequently. Thus, a highly accurate and high-speed simulation can be performed.

According to the present invention, the results of the processed simulations are output to a shared output unit. Therefore, the output unit can be consolidated so as not to require a disk or a visualizing apparatus for each simulation. Therefore, resources can be saved.

According to the present invention, when there is another simulation result that is more accurate than the results of the processed simulations, the results are updated with the other simulation result and output. In this manner, results differing in accuracy are sequentially updated to more accurate results. Therefore, a user can be informed of a result that is updated to the most accurate result.

According to the present invention, processors are allocated to the simulations, respectively, according to a predetermined condition, and the simulations are performed in parallel using the allocated processors. Therefore, when a parameter is specified to prioritize speed, more processors are allocated to simulations operating at a longer time step interval (at a higher speed), and less processors are allocated to simulations operating at a shorter time step interval (at a lower speed). On the other hand, when a parameter is specified to prioritize accuracy, more processors are allocated to simulations operating at a shorter time step interval (in a higher accuracy), and less processors are allocated to simulations operating at a longer time step interval (in a less accuracy). Therefore, the number of processors used in each simulation can be automatically decided in response to a request from a user.

According to the present invention, once a simulation is completed, a processor allocated to the completed simulation is allocated to another simulation, and the other simulation is performed using the allocated processor. In this manner, a processor having completed a simulation earlier is not kept in idle but is re-allocated to another simulation. Thus, the processor can be re-used.

According to the present invention, the results of the processed simulations are stored in the shared storage unit having a link structure. In this manner, for example, the mixed data can be merged into single data that is sorted in the order of the elapsed time of the simulations. Therefore, a user can refers to the simulation results in time series by checking the data from the top.

### BRIEF DESCRIPTION OF DRAWINGS

[FIG. 1] FIG. 1 is a schematic diagram for explaining an overview and features of a simulation apparatus according to a first embodiment of the present invention.
[FIG. 2] FIG. 2 is a block diagram of a configuration of the simulation apparatus according to the first embodiment.
[FIG. 3] FIG. 3 is a schematic diagram for explaining execute objects.
[FIG. 4] FIG. 4 is a schematic diagram for explaining a shared table.
[FIG. 5] FIG. 5 is a schematic diagram for explaining a processor re-allocation process.
[FIG. 6] FIG. 6 is a schematic diagram for explaining a shared table building unit correcting and updating the shared table.
[FIG. 7] FIG. 7 is a schematic diagram for explaining the shared table building unit correcting and updating the shared table.
[FIG. 8] FIG. 8 is a schematic diagram for explaining a shared table building process.
[FIG. 9] FIG. 9 is a flowchart of a process performed by the simulation apparatus according to the first embodiment.
[FIG. 10] FIG. 10 is a schematic diagram of a computer executing a simulation control program.

### EXPLANATIONS OF LETTERS OR NUMERALS

- 10: simulation apparatus
- 11: input unit
- 12: output unit
- 13: computing unit controlling I/F
- 14: control unit
- 14a: simulation initiating unit
- 14b: processor selecting unit
- 14c: simulation history receiving unit
- 14d: processor re-allocating unit
- 14e: shared table building unit
- 15: storage unit
- 15a: shared table
- 16a to 16c: computing unit
- 20: visualizing apparatus

### BEST MODE(S) FOR CARRYING OUT THE INVENTION

Embodiments of a simulation apparatus according to the present invention will be explained in detail with reference to the attached drawings.

### FIRST EMBODIMENT

In an embodiment described below, an overview and features of a simulation apparatus according to a first embodiment of the present invention, a configuration of the simulation apparatus, and a process performed thereby will be explained in this order. Then, the effect of the first embodiment will be explained.

### [Overview and features of simulation apparatus of first embodiment]

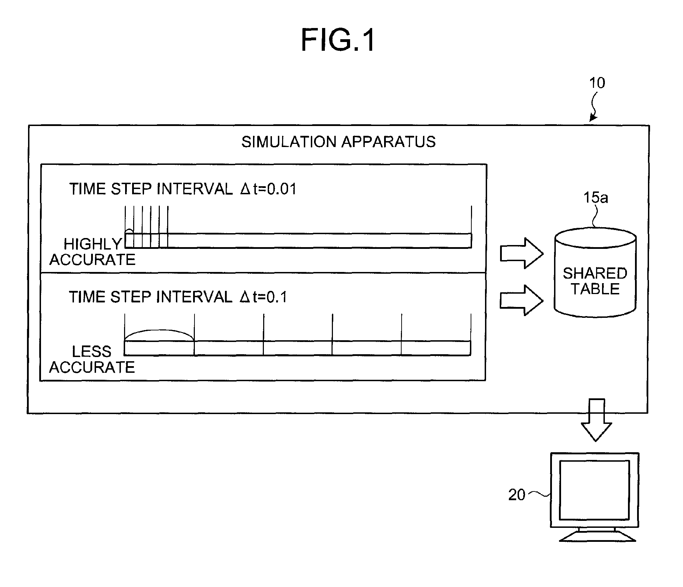

First, the overview and features of the simulation apparatus of the first embodiment will be explained with reference to FIG. 1. FIG. 1 is a schematic diagram for explaining the overview and the features of the simulation apparatus of the first embodiment.

The simulation apparatus 10 of the first embodiment is performing a simulation at a predetermined time step interval, and outputting data that is output at each of the steps. A salient feature of the simulation apparatus 10 is in its ability to perform a highly accurate simulation and a high-speed simulation.

More specifically, the simulation apparatus 10 of the first embodiment includes a shared table 15a that stores therein a plurality of simulation results, as depicted in FIG. 1.

The simulation apparatus 10 having such a configuration performs a plurality of simulations, each performed at a different time step interval, in parallel. More specifically, based on a plurality of execute objects, each having a different time step specified by a user, the simulation apparatus 10 calculates each of the simulation results. To explain it using the example depicted in FIG. 1, the simulation apparatus 10 performs a simulation calculated at a time step interval "Δt=0.01" (i.e., low speed but highly accurate), and a simulation calculated at the time step interval "Δt=0.1" (i.e., high speed but less accurate) in parallel. The time step interval may be specified in any unit as long as it is specified in a unit of "time". In this embodiment, the unit is specified in "seconds" for the convenience of the explanation. Therefore, "Δt=0.01" herein means a time step interval of 0.01 second.

The simulation apparatus 10 then stores the processed simulation results in the shared table 15a, and outputs the same to a visualizing apparatus 20. More specifically, the simulation apparatus 10 determines if the shared table 15a stores therein any simulation data that is more accurate than the processed simulation data. If the processed simulation data is more accurate, the simulation apparatus 10 writes the simulation data to the shared table 15a, and outputs the same to the visualizing apparatus 20.

In other words, the simulation apparatus 10 quickly outputs a result of a simulation processed at a longer time step interval to the visualizing apparatus 20, enabling a user to immediately plan for a measure to a disaster and the like. Subsequently, the simulation results are sequentially updated with more accurate results.

In this manner, the simulation apparatus 10 enables a simulation result processed at a longer time step interval to be obtained quickly, and more accurate simulation results to be obtained subsequently. Therefore, as described above, a high speed simulation and a highly accurate simulation can both be performed.

### [Configuration of simulation apparatus]

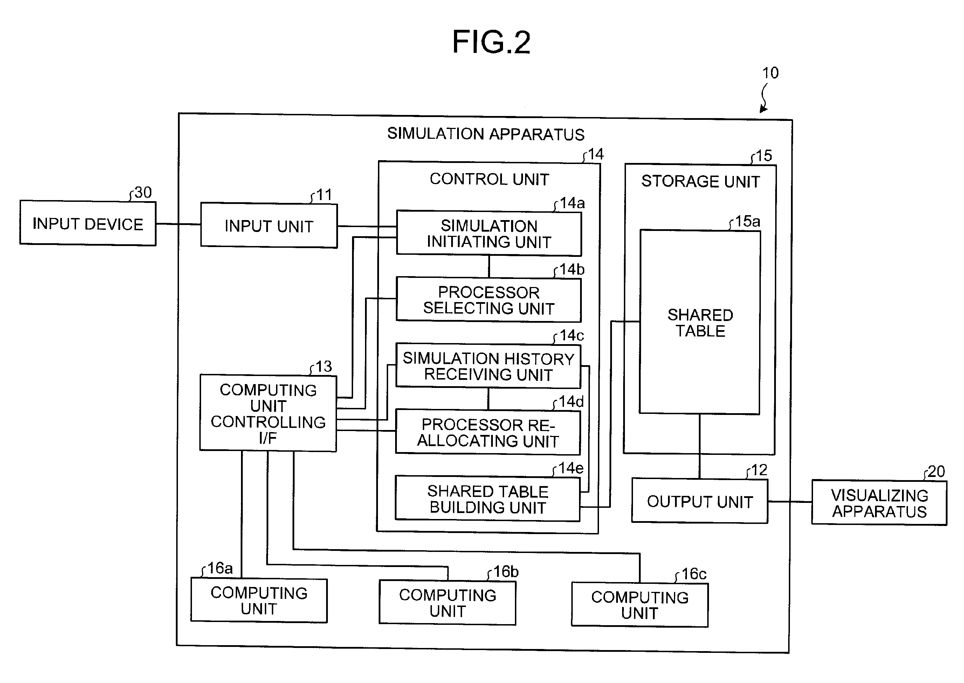

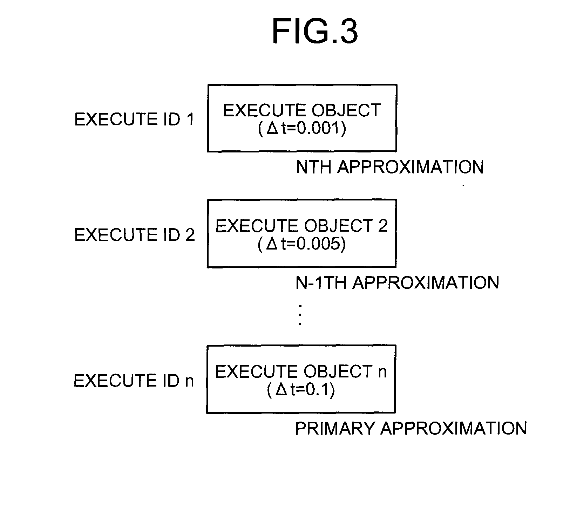

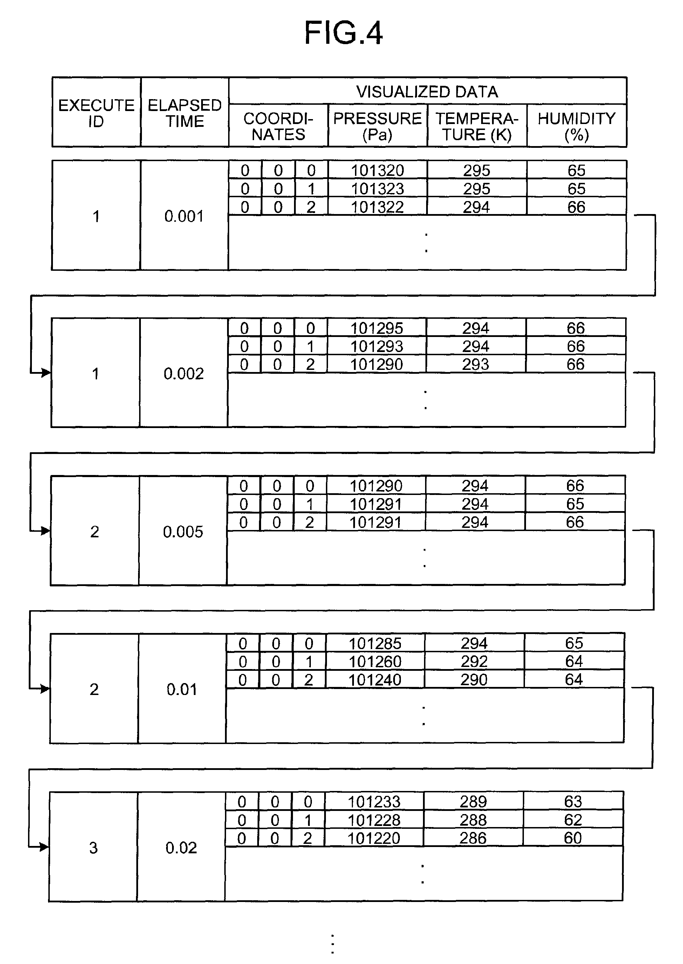

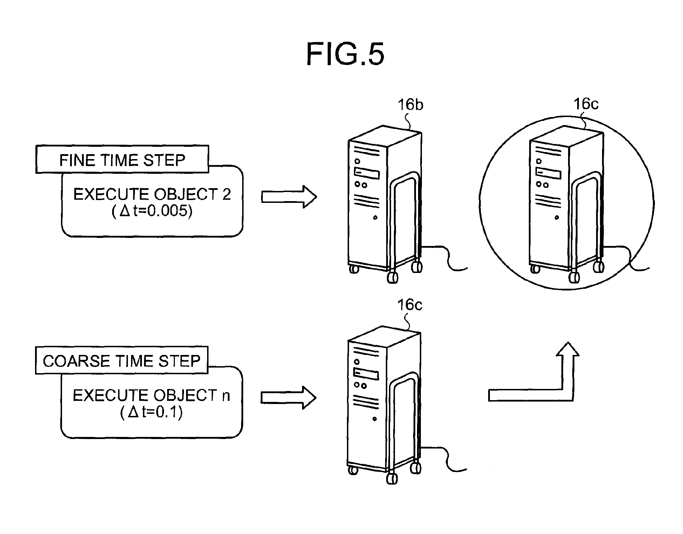

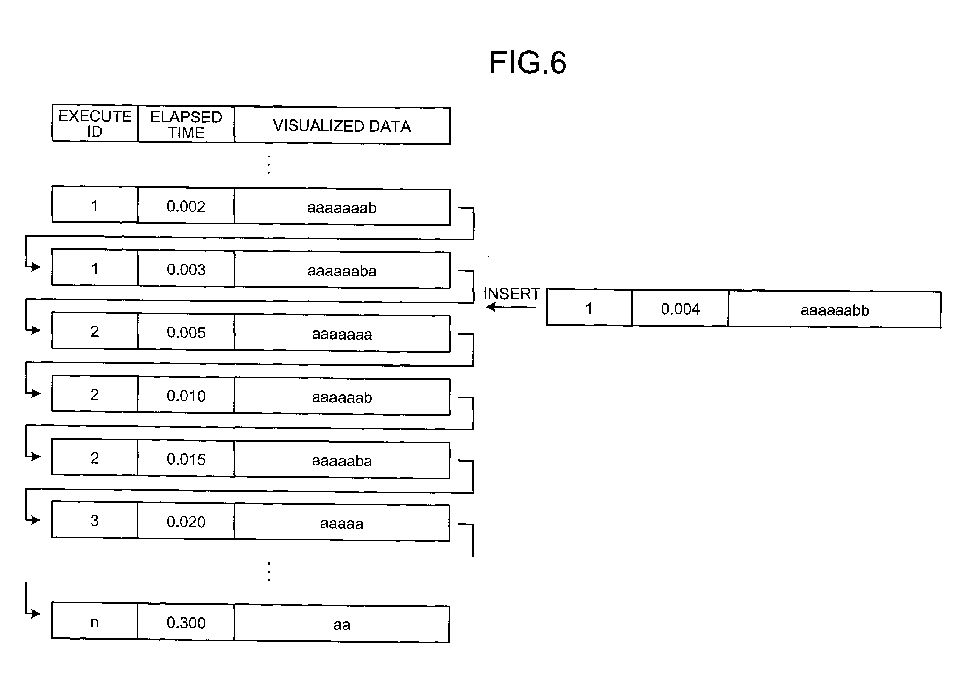

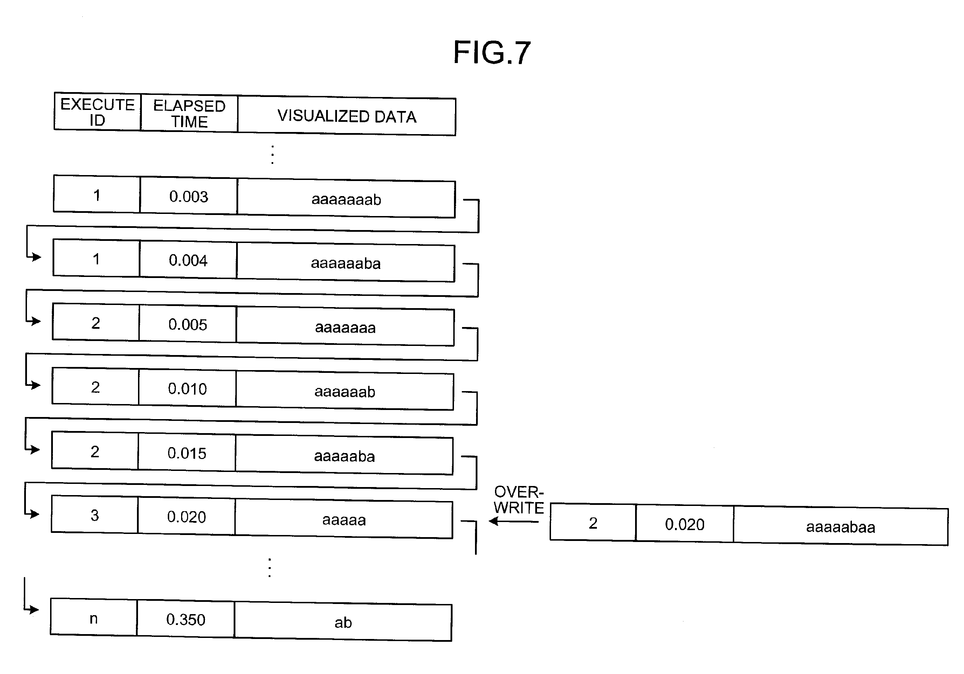

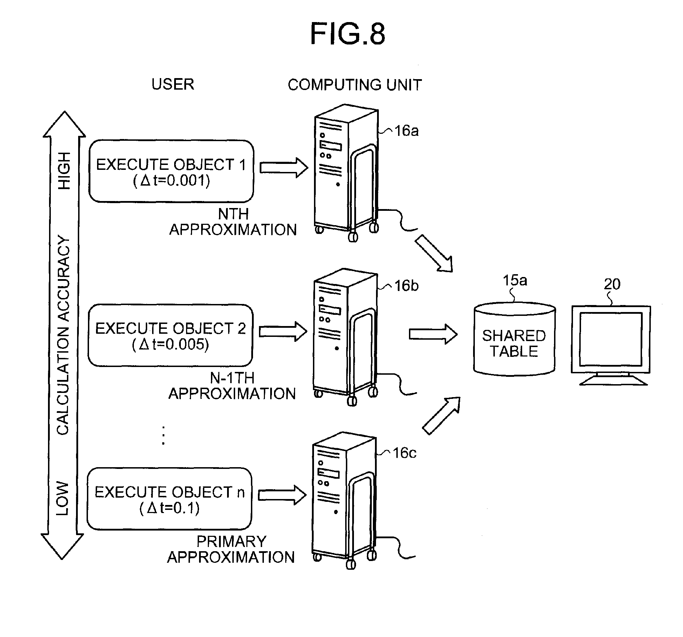

A configuration of the simulation apparatus 10 depicted in FIG. 1 will be explained with reference to FIGS. 2 to 6. FIG. 2 is a block diagram of a configuration of the simulation apparatus of the first embodiment. FIG. 3 is a schematic diagram for explaining execute objects. FIG. 4 is a schematic diagram for explaining a shared table. FIG. 5 is a schematic diagram for explaining a processor re-allocation process. FIGS. 6 and 7 are schematic diagrams for explaining a shared table building unit correcting and updating the shared table. FIG. 8 is a schematic diagram for explaining a shared table building process.

As depicted in FIG. 2, the simulation apparatus 10 includes an input unit 11, an output unit 12, a computing unit controlling interface (I/F) 13, a control unit 14, a storage unit 15, and a plurality of computing units 16a to 16c. The simulation apparatus 10 is connected to the visualizing apparatus 20 via the output unit 12. A process performed by each of these units will be explained. The computing units 16a to 16c may be computers that are independent from the simulation apparatus 10.

The input unit 11 receives instructions such as an instruction specifying a step interval used for each of the execute objects, an instruction specifying the number of processors used for each of the execute objects, an instruction to "prioritize speed" or to "prioritize accuracy", and an instruction for initiating a simulation. The input unit 11 is connected to an input device 30 such as a keyboard, a mouse, or a microphone.

For example, in an example depicted in FIG. 3, the input unit 11 receives, as a different step interval Δt, "Δt=0.001", "Δt=0.005", ... "Δt=0.1", to each of the execute objects. As a method of instructing parameters, such as a time step interval or the number of processors, a parameter table may be created in advance and populated with predetermined parameter values (not depicted in FIG. 2), so that a parameter can be specified by selecting the parameter on a monitor, using a known Graphical User Interface (GUI).

The output unit 12 outputs visualized data, stored in the shared table, to the visualizing apparatus 20. The visualizing apparatus 20 includes a monitor (or a display, a touch panel, etc.) or a speaker. The visualizing apparatus 20 displays visualized data, such as values of simulation results output from the output unit 12. In addition, the visualizing apparatus 20 may have other functions, such as those for converting output visualized data into a graph or an image (e.g., changing colors or shapes based on the output values), so that a user can understand the visualized data more easily.

The computing unit controlling I/F 13 controls communications about various information exchanged among the computing units 16a to 16c. More specifically, the computing unit controlling I/F 13 sends a simulated execute object to each of the computing units 16a to 16c realized by processors (hereinafter, the computing units 16a to 16c may be referred to as processors), and receives a simulation result from each of the computing units 16a to 16c.

The computing units 16a to 16c are realized by processors. The execute objects are generated in the processors, and a plurality of simulations each having a different time step interval is executed in parallel. More specifically, the computing units 16a to 16c are started in response to an initiating instruction issued by a simulation initiating unit 14a, which will be described later, and allocated to simulations, each having a different time step interval, by a processor selecting unit 14b, to perform the simulations.

Each of the computing units 16a to 16c then sends a result of the simulation performed at each of the time steps to a simulation history receiving unit 14c. The number of the processors in each of the computing units is not limited to one, and a plurality of processors may perform a simulation at a same time step interval. As mentioned above, the number of the processors, allocated to each of the execute objects, can be specified by way of an instruction provided to the input unit 11.

The storage unit 15 stores therein data and computer programs required for various processes executed by the control unit 14. As a computer program in a close relationship to the present invention, the storage unit 15 includes the shared table 15a. The shared table 15a has a link structure, and stores therein results of processed simulations.

More specifically, as depicted in FIG. 4, the shared table 15a maintains a mapping relationship between "execute ID" that uniquely identifies an execute object associated to a result of a processed simulation, "elapsed time" that represents a simulated time period, and "visualized data" that is the simulation result output to the visualizing apparatus 20. The shared table 15a stores therein such information in a link structure in the order of the elapsed time (pointers and the like are not depicted in FIG. 4).

The "elapsed time" is a time step interval Δt multiplied by the number of time steps required to complete the simulation, and indicates data output as a "visualized data" corresponds to a simulation result of which point in time. Values of the "elapsed time" may be different because the time step intervals are different. Therefore, the data during the "elapsed time" of the "visualized data" already stored in the shared table 15a may be sent as the "visualized data". Therefore, the shared table 15a has a structure linked in the order of the "elapsed time", so that new "visualized data" can be inserted easily.

The "visualized data" is different depending on a simulation model or what is simulated. In the example in FIG. 4, a space is segmented into three dimensional grids with coordinates ranging from (0, 0, 0) to (n, n, n), and results of the simulations executed for each of the grids are depicted. A pressure, a temperature, and humidity are depicted as data values. However, simulation results are not limited thereto. The coordinates may represent longitude, latitude, and altitude, or the data may include a seismic intensity, a magnitude, or a height of a wave. There are numerous types of "visualized data", depending on a simulation model or what is simulated.

The shared table 15a is constantly updated during a simulation. A user can obtain the latest information on the shared table in real time by accessing the visualizing apparatus. Moreover, through accessing the shared table, a user can collect data having only the specified execute ID (data in a specific time step interval), as long as before simulations of all of the execute objects are completed.
In this manner, in a large-scale simulation conducted with highly accurate execute objects and requiring a few days to obtain the final result, a user can select any data that is less accurate to see final results or interim results.

The control unit 14 includes an internal memory for storing therein computer programs specifying various processing procedures and necessary data, and executes various processes thereby. As computer programs in close relationship with the present invention, the control unit 14 includes the simulation initiating unit 14a, the processor selecting unit 14b, the simulation history receiving unit 14c, a processor re-allocating unit 14d, and a shared table building unit 14e.

The simulation initiating unit 14a instructs each of the computing units 16a to 16c to perform a simulation. More specifically, upon receiving a simulation initiating instruction via the input unit 11, the simulation initiating unit 14a instructs each of the computing units 16a to 16c to start up. The simulation initiating unit 14a notifies the processor selecting unit 14b of instructions received from the input unit 11, such as instructions specifying the time step intervals and the number of the processors used for an execute object corresponding to each of the time step intervals, and instructions to "prioritize speed" or to "prioritize accuracy".

Based on a predetermined condition, the processor selecting unit 14b allocates the processors to the computing units 16a to 16c, each performing a simulation at each of the time step intervals. More specifically, the processor selecting unit 14b allocates processors based on the instructions received from the simulation initiating unit 14a, such as instructions specifying the number of the processors used for an execute object corresponding to each of the time step intervals, and instructions to "prioritize speed" or to "prioritize accuracy".

To explain it with a specific example, when a user specifies the number of processors to be used in the computing units, each operating at a time step interval, the processor selecting unit 14b allocates the processors accordingly. When a parameter instructing to "prioritize speed" is received, the processor selecting unit 14b allocates more processors to a computing unit performing a simulation at a longer time step interval (at a higher speed), and less processors to a computing unit performing a simulation at a shorter time step interval (at a lower speed).

When a parameter instructing to "prioritize accuracy" is received, the processor selecting unit 14b allocates more processors to a computing unit performing a simulation at a shorter time step interval (in a higher accuracy), and less processors to a computing unit performing a simulation at a longer time step interval (in a lower accuracy). If a user does not specify any parameters, the processor selecting unit allocates all of the processors equally to the computing units.

The simulation history receiving unit 14c receives simulation results from the computing units 16a to 16c. More specifically, the simulation history receiving unit 14c asynchronously receives a simulation result from each of the computing units 16a to 16c at each of the time step intervals, and notifies the simulation result to the shared table building unit 14e, which will be described later. The simulation history receiving unit 14c also determines whether each of the computing units has completed the simulation and notifies the processor re-allocating unit 14d of the completion of each simulation, every time a simulation is completed.

As a computing unit completes a simulation at a time step interval, the processor re-allocating unit 14d allocates the processors, allocated to the computing unit that completed the simulation, to computing units performing other simulations. More specifically, upon being notified of completion of a simulation from the simulation history receiving unit 14c by way of a complete flag, the processor re-allocating unit 14d allocates the processors, allocated to the computing unit that completed the simulation, to computing units performing other simulations (see FIG. 5).

For example, the processor re-allocating unit 14d may determine how to allocate the processors to the computing units using the execute ID. In other words, a smaller execute ID value may be assigned to an execute object performing a more accurate simulation (at a shorter time step interval). In this manner, it can be assumed that a simulation of a computing unit executing an execute object having a smaller execute ID value than the completed execute ID value has not been completed.

The processor re-allocating unit 14d can allocate a processor used by the computing unit that completed a simulation and no longer in use to another computing unit corresponding to an execute ID having a smaller value than that corresponding to the computing unit that completed the simulation. The execute ID may be assigned in any order; a greater execute ID value may be assigned to an execute object performing a more accurate simulation, in the opposite manner as described above.

The shared table building unit 14e stores a result of a simulation, performed by each of the computing units 16a to 16c, in the shared table 15a having a link structure. More specifically, upon receiving a simulation result from the processor re-allocating unit 14d, the shared table building unit 14e determines if the shared table 15a stores therein any simulation result having the same elapsed time as that of the received simulation result.

If the shared table 15a does not store therein the simulation result having the same elapsed time as that of the received simulation result, the shared table building unit 14e adds the execute ID, the elapsed time, and the visualized data thereof to the shared table 15a.
At this time, because the data stored in the table are sorted in the order of the elapsed time, the shared table building unit 14e searches the table to find a position to insert the data in the order of the elapsed time, instead of appending the data at the end of the table, thus building a new link structure (see FIG. 6).

If the shared table 15a stores therein a simulation result having the same elapsed time as that of the received simulation result, the shared table building unit 14e determines if the received simulation result is more accurate than the simulation result having the same elapsed time.

If the received simulation result is more accurate than the simulation result having the same elapsed time, the shared table building unit 14e overwrites the simulation result having the same elapsed time at the position thereof, with the received simulation result, together with the execute ID, the elapsed time, and the visualized data thereof (see FIG. 7).

If the received simulation result is not more accurate than the simulation result having the same elapsed time, the shared table building unit 14e ends the process without any further procedures. In other words, the shared table building unit 14e keeps a more accurate simulation result in the shared table 15a. According to this embodiment, a link structure is used as the shared table 15a only to enable a piece of data to be easily inserted thereto. Therefore, it is also possible to use other methods such as sorting data in the order of the elapsed time using an ordinary relational database structure.

A process for building the shared table 15a will be explained with reference to FIG. 8. Each of the execute objects, performing a simulation at a time step interval (Δt) specified by a user, is generated in each of the computing units and the simulations are performed thereby. The results of the simulations are merged in the shared table 15a in a structure sorted in the order of elapsed time of the simulations. A user can see the simulation results, in the order of time, from the visualizing apparatus 20, by sequentially checking the visualized data stored in the shared table 15a.

### [Process performed by simulation apparatus]

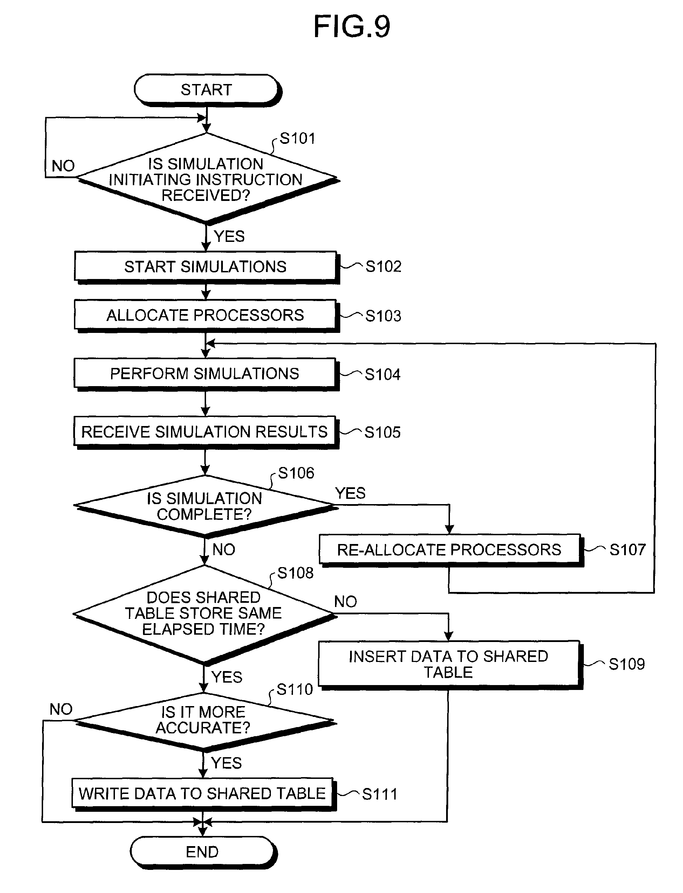

A process performed by the simulation apparatus 10 of the first embodiment will be explained with reference to FIG. 9. FIG. 9 is a flowchart of the process performed by the simulation apparatus 10 of the first embodiment.

As depicted in FIG. 9, upon receiving an instruction to initiate a simulation via the input unit 11 (YES at Step S101), the simulation initiating unit 14a instructs the computing units 16a to 16c to start up (Step S102). The simulation initiating unit 14a notifies the processor selecting unit 14b of instructions received from the input unit 11 such as instructions specifying the time step intervals, the number of the processors used for an execute object corresponding to each of the time step intervals, and instructions to "prioritize speed" or to "prioritize accuracy".

Based on the instructions received from the simulation initiating unit 14a, such as those specifying the number of the processor used for an execute object or instructions to "prioritize speed" or to "prioritize accuracy", the processor selecting unit 14b allocates the computing units 16a to 16c to the simulations performed at different time step intervals, and the processors used thereby (Step S103). The computing units 16a to 16c then perform the simulations (Step S104).

The simulation history receiving unit 14c asynchronously receives a simulation result from each of the computing units 16a to 16c at each of the time steps (Step S105), and notifies the simulation result to the shared table building unit 14e. The simulation history receiving unit 14c also determines if the simulation is completed by way of a complete flag received in place of a simulation result when the simulation is completed (Step S106). Upon completion of the simulation (YES at Step S106), the simulation history receiving unit 14c notifies the processor re-allocating unit 14d of the completion of the simulation.

Upon being notified of a completion of a simulation from the simulation history receiving unit 14c, the processor re-allocating unit 14d re-allocates the processors allocated to the completed simulation to other simulations (Step S107), and the simulations are thus continued. If the simulation is not completed (NO at Step S106), the process goes to Step S108.

Upon receiving a simulation result from the simulation history receiving unit 14c, the shared table building unit 14e determines if the shared table 15a stores therein any simulation result having the same elapsed time as that of the received simulation result (Step S108).

As a result, if the shared table 15a does not store therein the simulation result having the same elapsed time as that of the received simulation result (NO at Step S108), the shared table building unit 14e inserts the received simulation result to the shared table 15a in the order of the elapsed time (Step S109). If the shared table 15a stores therein a simulation result having the same elapsed time as that of the received simulation result (YES at Step S108), the shared table building unit 14e uses the execute ID to determine if the received simulation result is more accurate than the simulation result having the same elapsed time (Step S110).

As a result, if the received simulation result is more accurate than the simulation result having the same elapsed time (YES at Step S110), the shared table building unit 14e overwrites the simulation result having the same elapsed time, at the position thereof, with the received simulation result (Step S111). If the received simulation result is not more accurate than the simulation result having the same elapsed time (NO at Step S110), the shared table building unit 14e ends the process without any further procedures.

### [Effect of first embodiment]

As described above, the simulation apparatus 10 performs a plurality of simulations, each performed at a different time interval in parallel, to output processed simulation results. Therefore, the simulation apparatus 10 enables simulation results at longer time step intervals to be obtained quickly, and more accurate simulation results to be obtained subsequently. Hence, a high speed simulation and a highly accurate simulation can both be performed.

Further, according to the first embodiment, the simulation results are output to a shared output unit. Therefore, the output unit can be consolidated so that a disk or a visualizing apparatus are not required for each simulation. Thus, resources can be saved.

Furthermore, according to the first embodiment, if there is any other simulation result that is more accurate than a processed simulation result, the simulation result is updated with the other simulation result, and the updated result is output. In this manner, the results, each different in accuracy, are sequentially updated to a more accurate result. Therefore, a user can be notified of updated, the most accurate result.

Still further, according to the first embodiment, the processors are allocated to each of the simulations depending on a predetermined condition, and each of the simulations is performed in parallel using the allocated processors. For example, with the parameter to prioritize speed, more processors are allocated to the simulations having longer time step intervals (high speed), and less processors are allocated to the simulations having shorter time step intervals (low speed). With the parameter to prioritize accuracy, more processors are allocated to the simulations having shorter time step intervals (highly accurate), and less processors are allocated to the simulations having longer time step intervals (less accurate). Therefore, the number of the processors used for each of the simulations can be decided automatically depending on a user requirement.

Still further, according to the first embodiment, when a simulation is completed, the processors allocated to the completed simulation are allocated to other simulations, and the other simulations are performed using the allocated processors. Therefore, the processor that completes a simulation earlier are not kept in idle, and re-allocated to other simulations. In this manner, the processor can be re-used.

Still further, according to the first embodiment, the processed simulation results are stored in the shared table 15a having a link structure. In this manner, the mixed data can be merged into single data sorted in the order of the elapsed time of the simulations, for example. Therefore, a user can see the simulation results in the order of time by checking the data from the top thereof.

While an embodiment of the invention is described above, other embodiments or modifications are also possible. In the following, such embodiments or modifications will be explained.

### (1) System configuration and the like

The constituent elements of the apparatus depicted in the drawings are functionally conceptual, and need not be physically configured as illustrated. In other words, the specific mode of dispersion and integration of the constituent elements of the apparatus is not limited to that depicted in the drawings. The constituent elements of the apparatus, as a whole or in part, may be divided or integrated either functionally or physically based on various types of loads or use conditions. For example, the simulation initiating unit 14a and the processor selecting unit 14b may be integrated. All or some of the processing functions performed by the apparatus may be implemented by a CPU or a program that is analyzed and executed by the CPU, or by a wired-logic hardware.

Of the processes described above, all or part of the processes described as being performed automatically may be performed manually, or all or part of the processes described as being performed manually may be performed automatically with a known method. The processing procedures, the control procedures, specific names, and information including various data and parameters described above and illustrated in the drawings may be arbitrarily changed as required unless otherwise specified.

### (2) Computer program

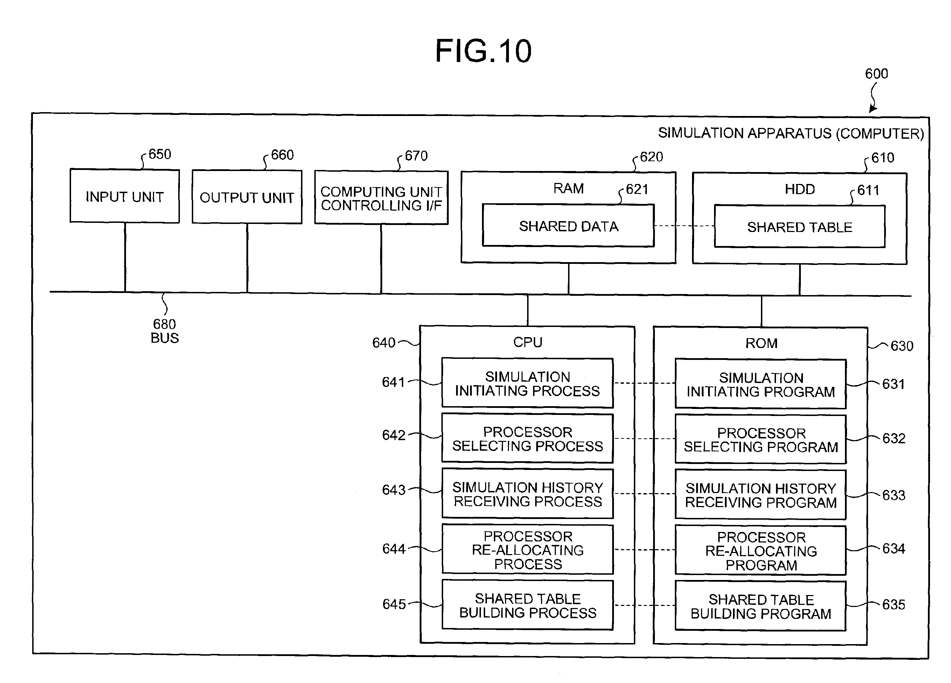

The various processes described in the above embodiment may be implemented by executing a computer program prepared in advance on a computer. With reference to FIG. 10, a description will be given of an example of such a computer that executes a computer program realizing the same function as described previously in the above embodiment. FIG. 10 is a schematic diagram of a computer that executes a simulation control program.

As depicted in FIG. 10, a computer 600, that is a simulation apparatus, includes a hard disk drive (HDD) 610, a random access memory (RAM) 620, a read-only memory (ROM) 630, a central processing unit (CPU) 640, an input unit 650, an output unit 660, and a computing unit controlling interface (I/F) 670, each connected via a bus 680.

The computer program having the same function as the simulation apparatus described in the above embodiment is stored in the ROM 630 in advance. The computer program, as depicted in FIG. 10, includes a simulation initiating program 631, a processor selecting program 632, a simulation history receiving program 633, a processor re-allocating program 634, and a shared table building program 635. The programs 631 to 635 may be integrated or distributed as appropriate as with the constituent elements of the simulation apparatus depicted in FIG. 2.

When the CPU 640 reads the programs 631 to 635 and executes them, the programs 631 to 635 come to function as a simulation initiating process 641, a processor selecting process 642, a simulation history receiving process 643, a processor re-allocating process 644, and a shared table building process 645, respectively, as depicted in FIG. 10. The processes 641 to 645 correspond to the simulation initiating unit 14a, the processor selecting unit 14b, the simulation history receiving unit 14c, the processor re-allocating unit 14d, and the shared table building unit 14e depicted in FIG. 2, respectively.

The HDD 610 includes a shared table 611 as depicted in FIG. 10. The shared table 611 corresponds to the shared table 15a depicted in FIG. 2. The CPU 640 registers data to the shared table 611, reads shared data 621 from the shared table 611, stores the read data in the RAM 620, and performs the simulations based on the shared data 621 stored in the RAM 620.

### INDUSTRIAL APPLICABILITY

As described above, the simulation control program, the storage medium, the simulation apparatus, and the simulation control method according to the present invention are useful in performing a simulation at time step intervals, and outputting the result of the simulation performed at each step, and especially suitable for performing a high-speed simulation with high accuracy.

## Claims

1. A simulation control program that causes a computer to implement a method for performing a simulation at predetermined sets of time step intervals and outputting a result of the simulation performed at each step, the simulation control program causing the computer to perform:
performing a plurality of simulations, each at a different time step interval, in parallel; and
outputting results of the simulations performed at the performing.

2. The simulation control program according to claim 1, wherein the outputting includes outputting the results of the simulations performed at the performing to a shared output unit.

3. The simulation control program according to claim 1, wherein, the outputting includes, when there is a simulation result more accurate than the results of the simulations performed at the performing, updating the results of the simulations with the simulation result before outputting the results of the simulations.

4. The simulation control program according to claim 1, further causing the computer to perform allocating processors to the simulations, respectively, according to a predetermined condition, wherein
the performing includes performing the simulations in parallel using the processors allocated at the allocating.

5. The simulation control program according to claim 1, further causing the computer to perform re-allocating, when a simulation is completed at the performing, a processor allocated to the simulation to another simulation, wherein
the performing includes performing the other simulation using the processor allocated at the re-allocating.

6. The simulation control program according to claim 1, further causing the computer to perform storing the results of the simulations performed at the performing to a predetermined storage unit having a link structure.

7. A computer-readable recording medium that stores therein a simulation control program that causes a computer to perform a simulation at a predetermined time step interval and output a result of the simulation performed at each step, the simulation control program causing the computer to perform:
performing a plurality of simulations, each at a different time step interval, in parallel; and
outputting results of the simulations performed at the performing.

8. A simulation apparatus that performs a simulation at a predetermined time step interval and outputs a result of the simulation performed at each step, the simulation apparatus comprising:
a simulation performing unit that performs a plurality of simulations, each at a different time step interval, in parallel; and
a result outputting unit that outputs results of the simulations performed by the simulation performing unit.

9. A simulation control method for performing a simulation at a predetermined time step interval and outputting a result of the simulation performed at each step, the simulation control method comprising:
performing a plurality of simulations, each at a different time step interval, in parallel; and
outputting results of the simulations performed at the performing.
